# EUROPEAN PATENT APPLICATION

(11) **EP 0 709 879 A1**
(43) Date of publication of application: **01.05.1996**
(21) Application number: 94921097.5
(22) Date of filing: 15.07.1994
(51) Int. Cl.: H01L 21/316

(54) **METHOD FOR MANUFACTURING SEMICONDUCTOR**

(30) Priority: 15.07.1993 JP 175738/93
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9401160
(87) International publication number: WO9502896

(57) **Abstract**

An object of the present invention is to provide a method of manufacturing high quality semiconductor which enables formation of an oxidized film with high dielectric strength even under a lower temperature.

In a process for forming an oxidized film by oxidizing a surface of semiconductor wafer or of a ,metallic thin film, an oxidized film is formed on a plasma atmosphere of a mixed gas including an inert gas and an oxygen to have the inert gas included in the oxidized film.

## Description

### TECHNICAL FIELD

The present invention relates to a method for manufacturing semiconductors, and more particularly to a method of manufacturing semiconductors suited to an oxidizing process in a semiconductor manufacturing process.

### BACKGROUND ART

Oxidizing method widely used in an LSI manufacturing process are divided to a dry oxidizing method under atmospheric pressure and a wet oxidizing method. In any case, oxidization is executed by introducing an oxygen gas under a high pressure in a range from 900 °C to 1000 °C, so that such problems as distortion of a wafer due to heat or rediffussion of impurities occur.

In recent years, researching efforts have been made to realize oxidization using an oxygen plasma under a low temperature. In this method, a high frequency wave electric field is loaded to an oxygen gas having a pressure in several tens mTorr to several hundreds mTorr to generate a O⁺ or O₂⁺ ions for forming an oxidized film. By placing a semiconductor wafer made from silicon or the like in oxygen ion or exited O₂ atmosphere, it become possible to form an oxidized film under a wafer temperature of 900 °C or below.

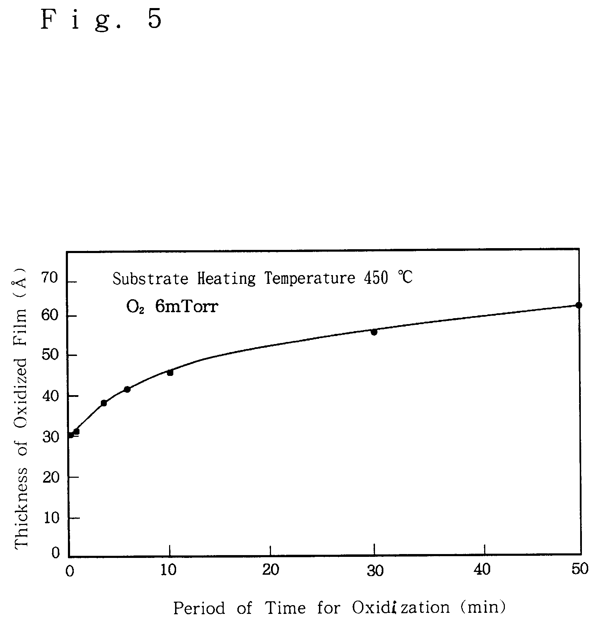

Fig.5 shows a relation between a film thickness of a silicon oxidized film generated by oxygen plasma and a period of time required for oxidation. A pressure of the oxygen gas in this case is 6 mTorr, and an oxygen plasma is generated by loading a 50 W high frequency wave electric field having a frequency of 100 MHz thereto. As shown in the figure, a quantity of silicon oxidized film increase as time for oxidization becomes longer, which indicates that a surface of a silicon wafer is oxidized in an oxygen plasma.

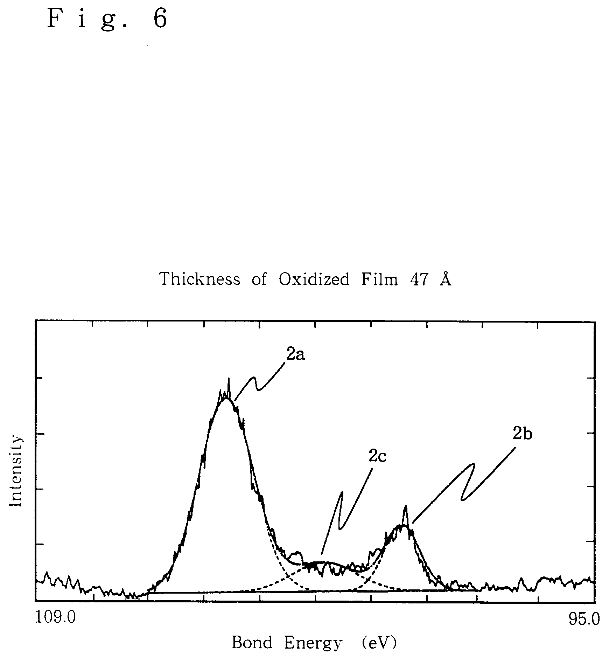

In the conventional technology as described above, at an interface between a surface layer of a semiconductor wafer and an oxidized film, a bonding state between atoms in the surface layers of the semiconductor wafer and oxygen atoms is different from that in the oxidized film. Fig.6 shows an X ray electron spectrographic spectrum of a silicon oxidized film (47 Å) formed by oxidizing a silicon wafer in an oxygen plasma. An X ray source used herein is AlKα. This figure shows 3 peaks caused due to existence of Si₂ₚ. Namely, in addition to the peak 2b from the silicon wafer and peak 2a caused to existence of SiO₂, the peak 2c can be observed. This peak 2c shows that bonding between Si and O other than SiO₂ exists in an interface between Si and the silicon oxidized film or in the silicon oxidized film. If bonding between Si and O Other than SiO₂ exists in an interface between Si and a silicon oxidized film or in the silicon oxidized film, dielectric strength fault easily occur in the oxidized film.

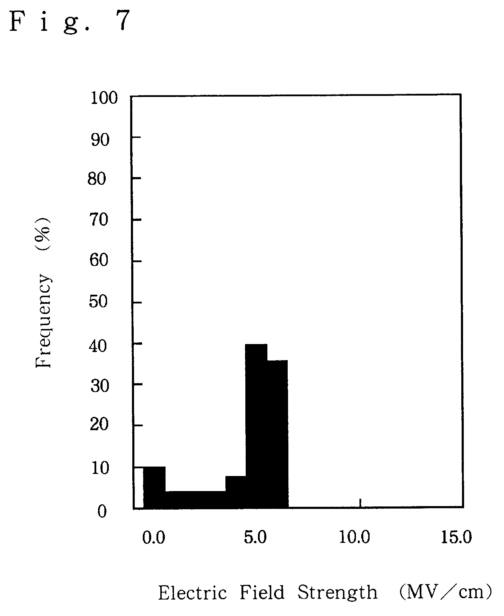

Fig.7 shows a result of examination of a dielectric strength distribution in a MOS diode prepared by forming an oxidized film by way of oxidizing a silicon wafer in an oxygen plasma and than forming an Al electrode on the oxidized film. In a case of a thermally oxidized film, the dielectric strength is 10 MV/cm or more, but in a case of an oxidized film formed in an O₂ film, the dielectric strength is at maximum 6 MV/cm, which is an extremely low value.

As described above, oxidization in an oxygen plasma as employed in the conventional technology has a merit that an oxidized film can be obtained under a low pressure, but it has also a demerit that the insulating capability of the obtained oxidized film is substantially inferior to that of a thermally oxidized film.

Under the circumstances as described above, it is an object of the present invention to provide a method for manufacturing high performance semiconductors which enables formation of an oxidized film which can be produced under a low temperature, but which has extremely insulating characteristics.

### DISCLOSURE OF THE INVENTION

The method for manufacturing semiconductor according to the present invention is characterized in that, in a process for forming an oxidized film by oxidizing a surface of semiconductor wafer or of a metallic thin film, an oxidized film is formed in plasma atmosphere of a mixed gas including an inert and an oxygen gas for the inert gas to be included in the oxidized film.

### FUNCTION

In the manufacturing method according to the present invention, by having an inert gas included on an oxidized film when the oxidized film is formed, although the reason has not been clarified yet, it becomes possible to have atoms in a surface layer of a semiconductor wafer (or a metallic thin film) bonded to oxygen atoms under stable conditions. For this reason, a film quality of the oxidized film is improved, and also the dielectric strength can be improved. In addition, it is required only that an inert gas is included when the oxidized film is formed, and even if the inert gas goes out of the oxidized film in a subsequent process, a stable bonding between semiconductor atoms (or metallic atoms) and oxygen atoms is maintained with the insulating capability also maintained.

### BRIEF DESCRIPTION OF THE DRAWINGS

Fig.1 is a schematic diagram showing a key section of an oxidized film forming apparatus according to the present invention.

Fig.2 is a graph showing dependence of a quantity of Ar gas released from an oxidized film formed according to the present invention on temperature.

Fig.3 shows an X ray photo-electron spectrum showing a bonding state between Si and O in an oxidized film formed according to the present invention.

Fig.4 is a histogram showing dielectric strength of an oxidized film formed according to the present invention.

Fig.5 is a graph showing a relation between a thickness of an oxidized film formed according the conventional technology and a period of time required for oxidation.

Fig.6 shows an X ray photo-electron spectrum showing a bonding state between Si and o in an oxidized film formed according to the conventional technology.

Fig.7 is a histogram showing dielectric strength of an oxidized film formed according to the conventional technology.

### (Description of reference numerals)

- 101: High frequency wave power source
- 102: Vacuum container
- 103: Upper electrode
- 104: High frequency wave power source
- 105: Lower electrode
- 106: Semiconductor wafer
- 107: Heater

### BEST MODE FOR CARRYING OUT THE INVENTION

Next, description is made for embodiments of the method for manufacturing semiconductor according to the figures.

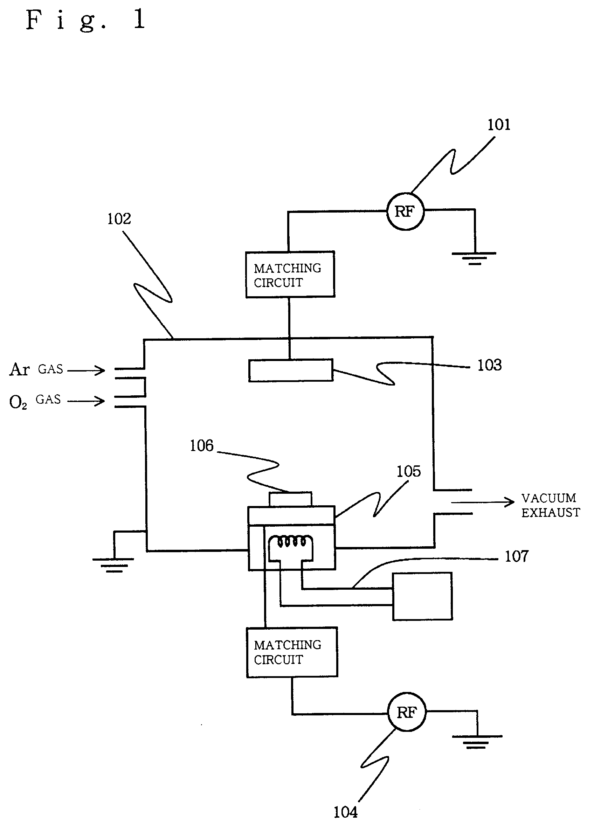

Fig.1 is a concept view showing an apparatus for oxidizing a semiconductor wafer with a plasma. The present apparatus is characterized in that a high frequency electric field having a frequency of, for instance, 100 MHz is loaded from a high frequency power source 101 to an upper electrode 103 to efficiently make an O₂ gas and a Ar gas into a chamber discharge for the purpose to generate a plasma.

On the other hand, by loading a high frequency wave electric field having a frequency of, for instance, several tens MHz to a lower electrode 105, an electric potential on a surface of a semiconductor wafer 106 place on the lower electrode 105 can be controlled. This electric potential can freely be changed by changing an output from the high frequency wave power source 104, and by providing controls so that the electric potential is smaller than that of an Ar/O₂ mixed plasma, it is possible to irradiate Ar ions in an Ar plasma onto the semiconductor wafer surface 106. Also the semiconductor wafer 106 is heated by a heater 107.

With this apparatus, it becomes possible to form a high quality SiO₂ film. For instance, by heating the Si wafer 106 with the heater 7 up to 450 °C and setting a pressure of an Ar gas to 30 mTorr and that of an O₂ gas 0.1 mTorr, and then 50 W high frequency wave electric filed with a frequency of 100 MHz isolated from the high frequency wave power source 101 to the upper electrode 03 to make the Ar and O₂ mixed gas discharge. The plasma potential of the Ar/O₂ mixed gas in this process is 15 V. On the other hand, when a 4 W high frequency wave electric field having a frequency of, for instance, 40 MHz is loaded to the lower electrode 105, an electric potential of -1 V is generated on the surface of the Si wafer 106. For this reason, a difference between a plasma potential of the Ar/O₂ mixed gas and a potential on the surface of the Si wafer 106 is 16 V, and it becomes possible to fully irradiate Ar⁺ ions onto the surface of the Si wafer. By irradiating Ar ions it becomes possible to include Ar in a Si oxidized film when the Si wafer is oxidized.

In the embodiment described above, electric discharge is executed after an Ar gas and O₂ gas are introduced, a plasma is generated, but an oxygen gas may be introduced after an Ar gas is introduced and a plasma is generated. In this case, a surface of a wafer is cleaned by Ar ions and then an oxidized film is formed, so that the insulating capability of the oxidized film is improved furthermore.

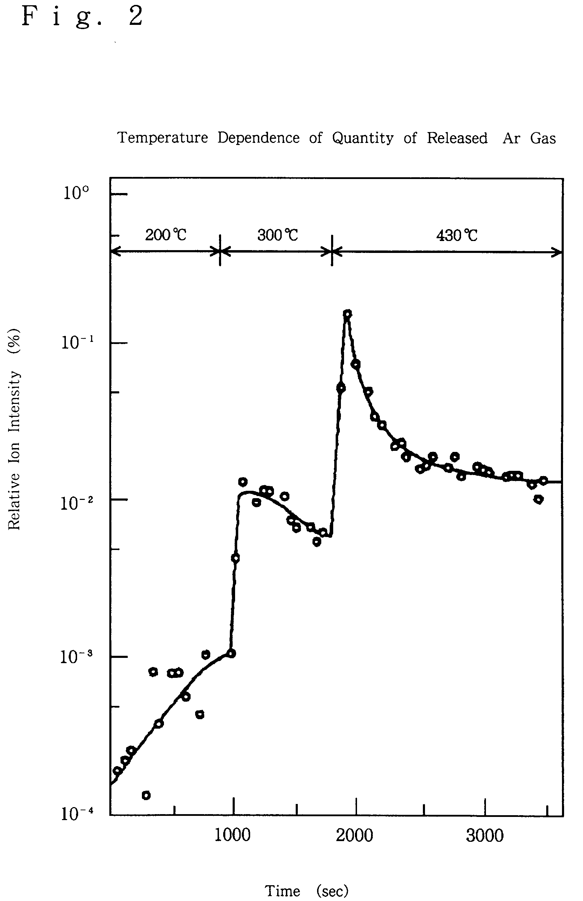

Then, a quantity of Ar in the silicon oxide film manufactured as described above was measured. Change in a quantity of Ar atoms released from the oxidized film, when a silicon wafer is heated, in association with change in temperature is shown in Fig.2. A quantity of released Ar was measured according to the atmospheric pressure ionization mass spectrometry. As clearly shown in this film, in association with rise of temperature, a quantity of Ar released from the silicon oxidized film also increases, and it was found out the quantity of released Ar gas that 1 x 10¹⁴ to 5 x 10¹⁴ Ar atoms are included in the oxidized film.

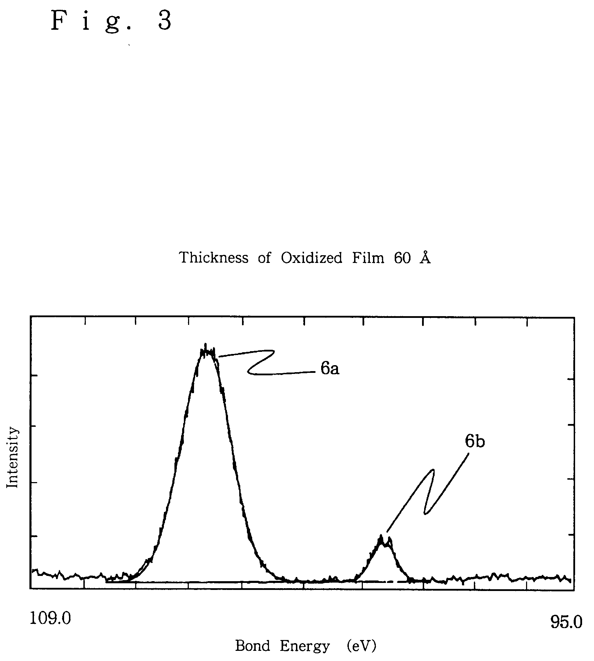

Fig.3 shows a result of investigation of a bonding state between Si atoms and O atoms in a silicon oxidized film according to the X ray photo-electron spectrography. A thickness of the oxidized film is 60 Å. A source of x ray was an AlKα. A shown in this figure, only the peal 6b from the silicon wafer and peak 6a from SiO₂ as an oxidized film are observed, and it is determined that bonding between Si and O other than SiO₂ does not exist therein.

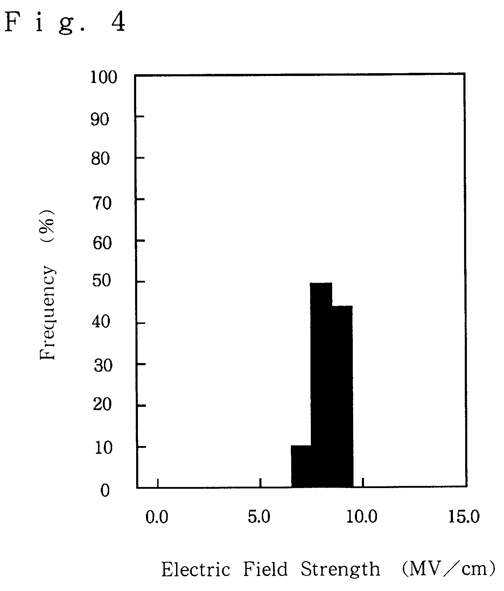

Fig.4 shows distribution of dielectric strength of a MOS diode manufactured by forming an Al electrode on an oxidized film having thickness of 60 Å or more. The dielectric strength is at max 9 MV/cm, and when compared to that conventional type of oxidized film formed only with an O₂ plasma shown in Fig.7, it is understood that the dielectric strength was improved by 3 MV/cm. Also the same measurement was executed to a MOS diode manufactured using an oxidized film from which an Ar gas was released, and the result shown in Fig.4 was obtained.

As clearly shown by the result described above, by having an Ar gas included in an oxidized film, it is possible to achieve stable bonding between Si atoms and oxygen atoms even under a lower temperature of 450 °C, and a silicon oxidized film having high dielectric strength can be formed.
Although description of the present embodiment above assumes oxidization of a silicon wafer, a semiconductor wafer is not limited to a silicon wafer, and this method is advantageously applied to oxidization of other types of semiconductor wafer or a metallic thin film formed on a semiconductor wafer. It has been confirmed that also a metallic thin film obtained by oxidizing a surface of metal (Ta) according to the sequence in this embodiment has higher dielectric strength.

Also in the description above, a thickness of the oxidized film was 60 Å, but the thickness is not always limited to this value. Also it was assumed in the above description that a gas included in an oxidized film was an Ar gas, but other inert gas may be used for the purpose. Although the quantity of inert gas included in an oxidized gas in terms of a number of atoms was in a range from 1 x 10¹⁴ to 5 x 10¹⁴, but it is needless to say that the quantity is mot limited to this value. Furthermore, temperature of the silicon wafer 106 in the above description was 450 °C, the temperature is not limited to this value.

### INDUSTRIAL APPLICABILITY

With the invention as claimed in Claim 1, atoms in a surface layer of a semiconductor wafer and oxygen atoms can be bonded to each other under stable conditions by having an inert gas included in the oxidized film, it is possible to provide a high quality semiconductor element having an oxidized film with high dielectric strength.

With the invention as claimed in Claim 2, an inert gas can effectively be included in an oxidized film in process of forming oxidized film.

## Claims

1. A method for manufacturing semiconductor characterized in that, in a process for forming an oxidized film by oxidizing a surface of semiconductor wafer or of a metallic thin film, an oxidized film is formed in plasma atmosphere of a mixed gas including an inert and an oxygen gas for the inert gas to be included in said oxidized film.

2. A method for manufacturing semiconductor according to Claim 1, wherein said oxidized film is a gate oxidized film.
